# FASCICULE DE BREVET EUROPEEN

(11) **EP 3 699 093 B1**
(45) Date de publication et mention de la délivrance du brevet: **12.05.2021**
(21) Numéro de dépôt: 20155313.8
(22) Date de dépôt: 04.02.2020
(51) Int. Cl.: B64D 47/02, B64D 41/00, B64D 45/02, B64C 1/14, B64D 43/00

(54) **ENGIN MOBILE MUNI D'UN SYSTÈME DE COMMUNICATION A CIRCUIT FLEX ENTRE UN DISPOSITIF DE MESURE EXTERIEUR ET UNE UNITE INTERIEURE**
BEWEGLICHE MASCHINE, DIE MIT EINEM KOMMUNIKATIONSSYSTEM MIT EINEM FLEX-SCHALTKREIS ZWISCHEN EINER EXTERNEN MESSVORRICHTUNG UND EINER INTERNEN EINHEIT AUSGESTATTET IST
MOBILE MACHINE PROVIDED WITH A COMMUNICATION SYSTEM WITH FLEX CIRCUIT BETWEEN AN EXTERNAL MEASURING DEVICE AND AN INTERNAL UNIT

(30) Priorité: 22.02.2019 FR 1901834
(43) Date de publication de la demande: 26.08.2020
(73) Titulaire: AIRBUS OPERATIONS (S.A.S.), 31060 Toulouse (FR)
(72) Inventeur: PLO, Aymeric, 31060 TOULOUSE Cedex 9 (FR); ALQUIER, Xavier, 31060 TOULOUSE Cedex 9 (FR); LASSERRE, Hervé, 31060 TOULOUSE Cedex 9 (FR)
(74) Mandataire: Gicquel, Olivier Yves Gérard

(56) Documents cités:
- US-A- 5 886 256
- US-A1- 2002 088 277
- US-A1- 2016 320 216
- US-A1- 2018 288 832

## Description

[La présente demande se rapporte à un système de communication de signaux transmis par un dispositif de mesure positionné sur la surface extérieure d'un engin mobile à une unité de traitement se trouvant à l'intérieur de celui-ci. D'autres types de signaux peuvent être concernés comme par exemple des signaux d'alimentation provenant d'une unité d'alimentation intérieure pour alimenter le dispositif de mesure extérieur.

La présente invention se rapporte en particulier au domaine des véhicules et plus particulièrement aux dispositifs de mesure utilisés lors des essais en vol d'un aéronef, en particulier un aéronef de transport. Les dispositifs de mesure sont en général fixés de manière temporaire le temps de l'essai sur la surface extérieure de l'aéronef, par exemple sur la surface des ailes. Le positionnement du dispositif est choisi en fonction des paramètres que l'on souhaite contrôler. Les données mesurées doivent être transmises à une unité de traitement se trouvant à l'intérieur de l'aéronef, très souvent à l'intérieur de la cabine. Le système de communication nécessite un câblage important pour transmettre les données mesurées à l'unité de traitement et de lourdes modifications sur l'aéronef pour offrir un passage traversant au câblage lui permettant depuis l'extérieur la connexion avec l'unité intérieure de traitement.

On connait de la demande de brevet FR1754171 déposée le 12 mai 2017 un système de communication utilisant une technologie sans fil. Un tel système oblige à l'utilisation de module spécifique à la technologie sans fil nécessitant l'implantation d'antennes et éventuellement de systèmes relais suivant le rayon d'action nécessaire et très souvent une alimentation par batterie interne. Un système à technologie sans fil s'il évite des modifications sur l'aéronef complexifie le système de communication tant au niveau de l'installation que de la maintenance.

Le document US2016320216 concerne un dispositif de mesure susceptible d'être accolé sur une paroi extérieure d'un objet mobile ou d'un objet fixe se trouvant dans un écoulement d'air pour mesurer des grandeurs physiques. Un circuit flex est utilisé pour la communication des données.

La présente invention a pour but de proposer un nouveau système de communication permettant d'éviter toute modification sur l'aéronef pour la communication entre le dispositif de mesure extérieur et l'unité intérieure de traitement.

A cet effet, la présente invention concerne un engin mobile comprenant un fuselage présentant au moins une porte, à l'intérieur duquel se trouve une unité de traitement de mesures réalisées par au moins un dispositif de mesure installé à l'extérieur dudit fuselage, le système de communication entre l'unité de traitement et le dispositif de mesure comprenant un circuit flex apposé au moins partiellement à plat au niveau de l'encoignure de porte entre la porte et le bord de l'ouverture pratiquée dans le fuselage auquel la porte s'associe et dont l'une des extrémités intérieure se trouve à l'intérieur du fuselage et l'autre extérieure à l'extérieur.

De cette manière, le circuit flex en permettant de traverser la paroi du fuselage par l'intermédiaire de l'ouverture d'une porte (le terme porte étant entendu dans un sens large comme il sera vu plus loin dans la description) permet d'éviter d'avoir à apporter des modifications à l'engin mobile tout en conservant l'étanchéité offerte nécessaire.

L'invention prévoit au moins l'une des caractéristiques optionnelles suivantes, prises isolément ou en combinaison.

Le circuit flex est positionné à plat sur toute sa longueur contre la surface sur laquelle il s'applique de part et d'autre de la porte.

Le circuit flex est fixé de manière amovible sur la surface extérieure du fuselage, sur la zone de transition et sur la surface d'une structure intérieure.

Deux boitiers de connexion sont prévus à l'intérieur et à l'extérieur du fuselage pour la connexion directe des extrémités du circuit flex.

Le circuit flex comprend des renforts de protection au niveau d'au moins une arête de l'encoignure de porte.

Le circuit flex comprend un blindage de protection contre la foudre.

Une zone d'interruption du blindage est prévue au niveau de l'encoignure de porte.

Le circuit flex comprend une extension permettant d'atteindre un point de masse de l'aéronef.

L'extension comprend une zone dépourvue de couche d'isolant et au niveau de laquelle est prévu un pont conducteur pour le passage de la foudre vers un point de masse de l'aéronef.

Le ou les dispositifs de mesure sont positionnés sur la surface extérieure de l'aéronef et liés par liaison filaire à l'extrémité extérieure du circuit flex.

Plusieurs circuits flex sont positionnés respectivement au niveau d'au moins deux portes différentes.

L'engin mobile consiste en un aéronef.

D'autres buts, caractéristiques et avantages ressortiront de la description de l'invention qui va suivre, description donnée à titre d'exemple uniquement non limitatif, en référence aux dessins ci-annexés dans lesquels :
[Fig. 1] est une vue partielle de dessus d'un aéronef pourvu d'un système de communication selon la présente invention ;
[Fig. 2] est une représentation schématique en vue en coupe de côté d'un système de communication au niveau du bord inférieur d'une porte en position de fermeture ;
[Fig. 3] est une représentation schématique en vue de face depuis l'extérieur de la porte représentée sur la figure 2 ;
[Fig. 4] est une représentation schématique en plan de dessus du circuit flex du système de communication selon la présente invention ;
[Fig. 5] est une représentation schématique en coupe des différentes couches comprises dans le circuit flex de la figure 3 ;
[Fig. 6] est une représentation schématique en perspective d'un bord de porte de forme différente de celle de la figure 2 dans lesquelles les arêtes sur lesquelles repose un circuit flex du système de communication selon la présente invention sont bien visibles ;
[Fig. 7] est une représentation schématique en perspective d'un circuit flex du système de communication selon la présente invention installé sur un bord de porte de forme différente de celles des figures 2 et 6 et pour laquelle les arêtes du bord de porte sont mises en évidence en pointillés.

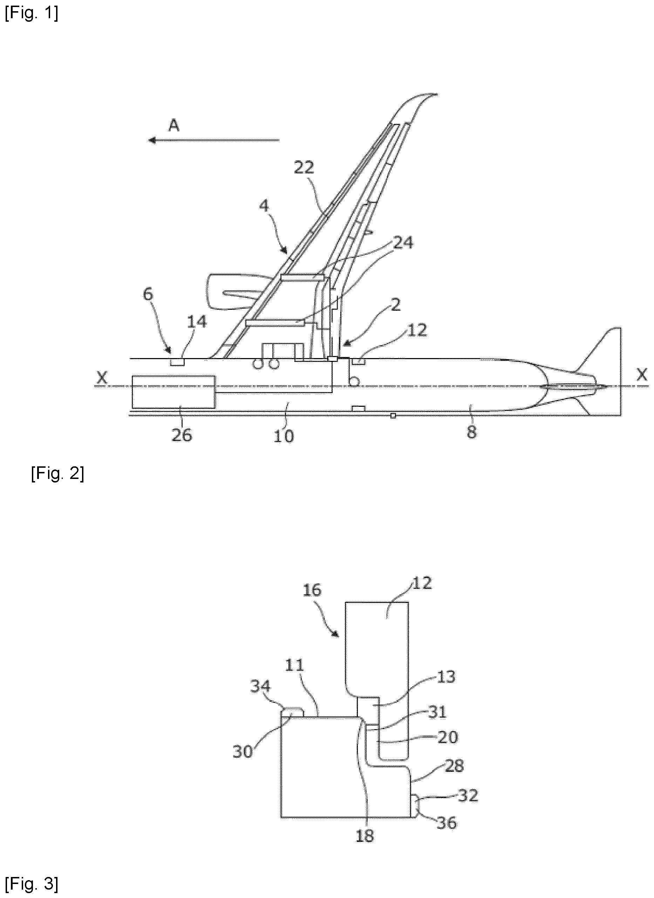

Comme illustré sur la figure 1, la présente invention se rapporte à un système 2 de communication pour un système 4 de mesure de paramètres physiques utilisés pour analyser le fonctionnement d'un engin 6 mobile. L'étude des résultats permet d'en comprendre le comportement et d'en améliorer ou valider les performances. L'engin mobile peut être de tout type : maquette d'essai (la maquette étant considérée comme mobile du fait du mouvement du flux d'air environnant simulant le mouvement de la maquette qui est immobile), véhicule tel qu'aéronef, train, bus, camion, voiture ... Dans la suite de la description, on s'intéresse à l'exemple de l'aéronef 6 de transport.

Un aéronef 6 tel que représenté sur la figure 1 comprend un corps 8 formant un espace fermé, appelé plus communément fuselage. Dans un aéronef de transport, se trouve notamment dans la partie avant du fuselage un cockpit et à l'arrière du cockpit une cabine 10 présentant un plancher 11 (voir figure 2). Les termes avant et arrière sont utilisés en référence au sens de déplacement de l'aéronef en vol représenté par la flèche A sur la figure 1. On supposera que l'aéronef 6 repose sur un sol horizontal et que tout plan parallèle au sol est horizontal et tout plan perpendiculaire au sol est vertical. Les termes inférieur et supérieur sont pris en référence à cette direction verticale.

Comme illustré sur les figures 1 à 3, le fuselage 8 comporte au moins deux portes 12, 14. Le fuselage 8 présente au niveau de chacune des portes 12, 14 une ouverture 16 dont le bord vertical présente des moyens par exemple de type charnière pour lier de manière articulée la porte au fuselage. Le bord 18 inférieur horizontal de la porte se trouve au même niveau que le plancher 11. L'extrémité périphérique de la porte est pourvue d'un joint 13 pour rendre la connexion avec le fuselage étanche. Certaines portes comme par exemple celles offrant une issue de secours peuvent ne pas avoir de liaison articulée. Elles peuvent être utilisées dans le cadre de l'invention mais présentent moins d'intérêt compte-tenu de la difficulté accrue pour la mise en place et le retrait du système de communication selon l'invention. La présente invention peut s'appliquer à d'autres ouvertures dans l'aéronef présentant une porte 12 pris dans un sens large : il peut s'agir par exemple d'un panneau d'accès à l'aéronef, d'une trappe tel qu'une trappe d'accès au niveau du ventre mou de l'aéronef. Un joint 13 d'étanchéité peut être prévu pour l'étanchéité au niveau de l'ouverture en question. Quel que soit l'application, le fuselage de l'engin mobile comprend une structure 11 intérieure au fuselage suffisamment proche de la porte pour y apposer une partie du système de communication, dans le cas d'espèce, un plancher 11.

Le bord 18 de l'ouverture 16 comme le montre la coupe transversale de la figure 2 présente un profil en forme d'escalier en L contre lequel vient s'appliquer la forme complémentaire en L inversé du bord 20 de la porte 12, 14. La direction transversale correspond à une direction perpendiculaire à la direction longitudinale de l'aéronef correspondant à la direction de l'axe X-X sur la figure 1. L'aéronef 6 comporte également une voilure 22 fixée au fuselage 8. L'ensemble bien connu des éléments composant un aéronef ne sera pas plus décrit en détail puisque non nécessaire à la description de l'invention.

L'ensemble de mesure comprend au moins un dispositif 4 de mesure permettant la mesure de grandeurs physiques notamment lors d'essai en vol. Le dispositif 4 de mesure est disposé à l'extérieur du fuselage 8 de l'aéronef. Il peut se présenter par exemple sous la forme d'un support 24 de capteurs souple apposé sur la surface extérieure de l'aéronef dont il épouse les contours. Dans la forme de réalisation illustrée sur la figure 1, le support 24 est fixé à la surface extérieure de la voilure 22. Le support 24 est un exemple ; d'autres types de dispositifs de mesure peuvent être utilisés comme une caméra, un microphone ou autres. L'ensemble de mesure comprend également une unité 26 de traitement des données mesurées réalisées. L'unité de traitement 26 est disposée à l'intérieur du fuselage, par exemple dans la cabine 10. L'unité de traitement 26 a pour fonction d'acquérir les signaux en provenance du ou des dispositifs 4 de mesure extérieurs et éventuellement de les traiter et/ou de les renvoyer à une autre unité. Elle peut également jouer un rôle d'alimentation du ou des dispositifs de mesure sachant que ce rôle peut être réalisé par un autre composant indépendant. La présente invention s'intéresse plus particulièrement au système de communication entre le dispositif 4 de mesure extérieur et l'unité 26 de traitement intérieur de signaux mesurés par le ou les dispositifs 4 et éventuellement de signaux d'alimentation du ou des dispositifs 4 ou tout autre signal comme par exemple un signal de synchronisation nécessaire dans les échanges réalisés au sein de l'ensemble de mesure.

Le système de communication utilise un circuit 28 flex pour permettre de traverser la paroi de l'aéronef au niveau des portes 12, 14 sans avoir à la percer ou la modifier. Le terme de circuit flex dans la présente invention recouvre tout circuit imprimé flexible, à savoir un circuit imprimé intégré à un substrat présentant la particularité d'être souple comme un substrat élastomère ou plastique. Le circuit flex est de type connu, appelé communément en langue anglo-saxonne flex PCB pour « flexible printed circuit board ». Le circuit 28 flex présente également en plus d'être souple une deuxième caractéristique qui est celle de présenter une faible épaisseur à savoir inférieure à l'épaisseur que présenterait la majorité des câbles à performance égale.

Le circuit 28 flex permet la connexion entre le dispositif 4 de mesure extérieur et l'unité 26 de traitement intérieur à l'aéronef. Il est placé à plat au niveau du passage de la porte de manière que l'une de ses extrémités 30 se trouve à l'intérieur du fuselage de l'aéronef, à savoir ici dans l'exemple donné à l'intérieur de la cabine et l'autre extrémité 32 à l'extérieur du fuselage de l'aéronef ; le circuit 28 est accolé à la surface du fuselage au niveau de l'encoignure de porte. Du fait de sa structure plate et peu épaisse, le circuit flex n'endommage pas le joint 13 de porte ni ne dégrade ses performances et limite la pression exercée sur celui-ci. Le circuit flex englobe un circuit imprimé dans un substrat qui évite de créer des passages pour l'air si les fils de profil plus saillant étaient dissociés.

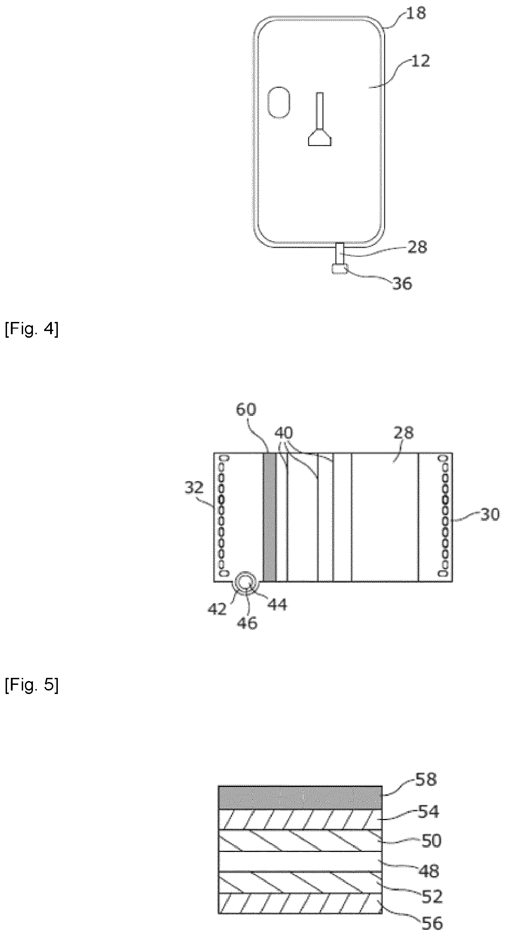

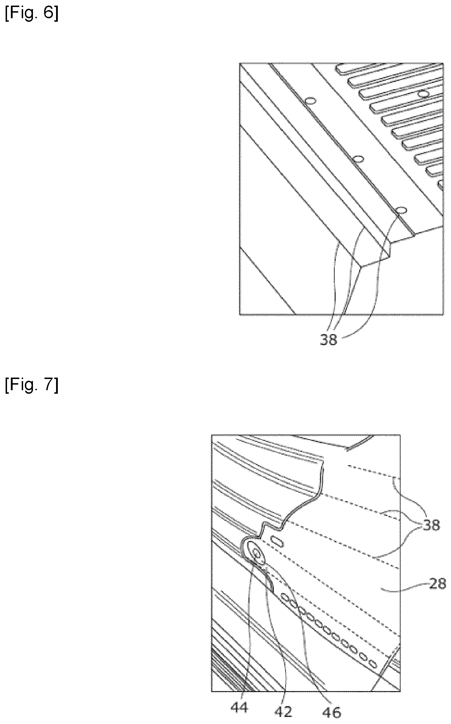

Comme illustré sur les figures 6 et 7, l'encoignure de porte peut présenter plusieurs marches présentant des arêtes 38 saillantes. Pour ne pas endommager le circuit imprimé, des renforts 40 (représentés par une ligne continue sur la figure 4) sont prévus sur le circuit flex au niveau correspondant aux arêtes 38 lorsque le circuit flex 28 est disposé dans l'aéronef. Selon une forme possible des renforts 40, ils sont constitués d'une épaisseur plus importante du substrat ; selon une autre forme de réalisation, ils pourraient être réalisés par l'insertion dans le substrat d'un patch de matériau différent.

Le circuit 28 selon une forme de réalisation illustrative est fixé depuis son extrémité intérieure 30 jusqu'à son extrémité extérieure 32 sur la surface d'une structure intérieure ici le plancher 11, sur la surface extérieure du fuselage ainsi que sur la surface de la zone 31 faisant le lien entre le plancher et la surface extérieure du fuselage, appelée zone 31 de transition. Dans la forme de réalisation illustrée, le circuit 28 flex est positionné au moins partiellement à plat au niveau de la zone de transition et ici sur toute sa longueur de manière à s'y superposer et former une unité avec la surface sur laquelle il est accolé de manière affleurante. Le circuit est fixé au fuselage, à la zone de transition et au plancher de la cabine par exemple avec des moyens lui permettant d'être amovible. Il peut par exemple être fixé à l'aide d'un ruban à double face de fixation ou une colle ou un film spécifique.

Le circuit flex comprend plusieurs couches qui sont représentées de manière schématique sur la figure 5 en coupe. Le circuit 28 flex comprend une couche 48 correspondant au circuit imprimé. Au-dessus et en dessous du circuit imprimé sont prévues des couches 50, 52 d'isolant appelées supérieure 50 pour la couche se trouvant au-dessus du circuit 48 et inférieure 52 pour la couche se trouvant en dessous, ces couches permettant d'éviter des court-circuits. Dans cette forme de réalisation, les couches 50, 52 d'isolant correspondent au substrat mentionné plus haut. Le circuit flex est blindé pour le protéger contre la foudre : un blindage 54 supérieur au-dessus de la couche d'isolant supérieure et un blindage 56 inférieur en-dessous de la couche d'isolant inférieure. Une couche 58 de protection contre la corrosion est prévue pour recouvrir l'ensemble à l'opposé de la surface du circuit flex destinée à être fixée à l'engin mobile.

Pour permettre de conduire la foudre vers un ou plusieurs points de masse sur la structure externe du fuselage de l'aéronef, le circuit flex comprend des zones 46 (que l'on a représenté en transparence de manière visible sur la figure 7) non isolées permettant de relier électriquement les blindage inférieur et supérieur à un point de masse de la structure. Les zones 46 sont donc réalisées géométriquement sur le circuit en vis-à-vis d'éléments au niveau de l'aéronef conduisant à un ou plusieurs points de masse. Dans la forme de réalisation illustrée, le circuit flex 28 comprend une extension 42 permettant d'atteindre un élément de l'aéronef susceptible de conduire jusqu'à un point de masse, se présentant dans l'exemple illustré sous la forme d'une vis de fixation du seuil de porte. La vis de fixation traverse le circuit flex au niveau de l'extension 42. Le circuit flex comporte également une zone 60 (représentée par une bande grise en transparence pour la rendre visible sur la figure 4) au niveau de laquelle le blindage inférieur 56 et supérieur 54 est interrompu, appelée zone 60 d'interruption, qui est placée en vis-à-vis de l'encoignure de porte ou encore du joint de porte afin d'éviter de créer un point d'entrée pour la foudre vers l'intérieur du fuselage en offrant un chemin d'entrée privilégié vers la structure de l'aéronef. Il n'est pas nécessaire de prévoir une liaison vers un point de masse pour le blindage inférieur et supérieur se trouvant à l'intérieur de l'aéronef non exposé à la foudre d'où le positionnement de la zone 60 d'interruption à la frontière entre l'intérieur et l'extérieur de l'aéronef matérialisé par l'encoignure de porte ou encore le joint de porte. Dans la forme de réalisation illustrée, l'extérieur de l'aéronef est caractérisé par l'exposition à un impact de foudre contrairement à l'intérieur de l'aéronef. La forme du circuit flex dépend donc de l'emplacement au niveau duquel le circuit doit être placé et de sa configuration pour adapter le positionnement des renforts 40 et des éléments de protections contre la foudre, zone 46 non isolée, blindage 54, 56, zone 60 d'interruption, extension 42 si nécessaire. Le circuit flex présente une forme globalement longiligne rectangulaire donné par le circuit imprimé d'où le terme utilisé d'extension si la forme rectangulaire ne permet pas d'atteindre les éléments de l'aéronef connectés à des points de masse. Dans le cas où la forme rectangulaire permet d'atteindre et de recouvrir au moins un tel élément, le terme extension recouvre également la partie (ou les parties) du circuit flex destiné(es) à la liaison avec un (ou plusieurs) point(s) de masse même si ce n'est plus à proprement parler une extension au sens géométrique du terme. Comme le montrent les figures 4 et 7, dans la forme illustrée, l'extension 42 du circuit flex comprend une zone 44 correspondant à la localisation de la vis une fois le circuit flex installé sur l'aéronef. Au niveau de cette zone 44, il n'y a pas de couche d'isolant mais un pont conducteur vers un point de masse de l'aéronef se présentant dans l'exemple illustré sous la forme de rondelles 46 conductrices et par exemple métalliques assemblées au-dessus et en-dessous du circuit flex, au même niveau que le blindage et autour de l'orifice prévu pour la vis dans l'aéronef. Lorsque le circuit flex 28 est installé sur l'aéronef, la zone 44 est placée en correspondance avec l'orifice prévu pour recevoir la vis. Lorsque la vis est introduite dans l'aéronef, elle s'appuie contre la rondelle 46 conductrice prévue sur le circuit flex et permet d'offrir un chemin privilégié pour la foudre par les rondelles 46 et la vis afin d'atteindre un point de masse interne à l'aéronef.

Les extrémités 30, 32 du circuit flex comme le montre la figure 4 portent les extrémités de pistes. Les extrémités des pistes comme montré sur les figures 4 et 7 peuvent être liées directement électriquement à des zones de contact pour être ensuite soudées ou connectées aux éléments de liaison prévus pour connecter le circuit flex à l'unité 26 de traitement et aux dispositifs de mesure. Selon une autre forme possible représenté sur la figure 2, l'ensemble des extrémités de piste peuvent aussi être enveloppé dans un boitier de connexion 34, 36. Deux boitiers 34, 36 de connexion peuvent être prévus à l'intérieur et à l'extérieur du fuselage pour permettre la connexion de chacune des extrémités 30, 32 du circuit 28 flex. Les boitiers 34, 36 sont pré équipés avant le montage du circuit flex sur aéronef. Les boitiers 34, 36 par rapport aux extrémités nues permettent d'intégrer des fonctions complémentaires. Ainsi par exemple les boitiers 34, 36 peuvent intégrer des composants écrêteurs tels que des diodes afin de protéger le circuit flex contre des perturbations résiduelles de la foudre. L'un des boitiers 34 intérieur est fixé à une structure intérieure à l'intérieur du fuselage et dans l'exemple illustré sur le plancher 11. L'autre boitier 36 extérieur est fixé à l'extérieur du fuselage et dans l'exemple illustré sur la surface extérieure du fuselage. Les boitiers 34 et 36 sont fixés à proximité de la porte 12, 14 au niveau de laquelle le circuit flex est installé à une distance telle qu'une fois le circuit flex apposé de tout son long contre la surface du plancher, de la zone de transition et du fuselage, les extrémités respectivement intérieure 30 et extérieure 32 du circuit flex se trouvent positionnées au niveau des boitiers respectivement intérieur 34 et extérieur 36 pour s'y connecter aisément. De ce fait, lorsque la porte 12, 14 est en position fermée, le circuit flex étant superposé et fixé à plat au moins au niveau de la zone de transition et dans la forme illustrée sur toute sa longueur et étant connecté par ses extrémités aux boitiers 34 et 36, il n'induit aucun effort sur le joint 13 et évite de créer un espace ayant un effet sur l'étanchéité de la fermeture de porte au niveau des fuites d'air et mais également du bruit associé. L'unité 26 de traitement est connectée par liaison filaire au boitier 34. Le boitier 36 forme une interface pour la connexion du circuit 28 avec le dispositif 4 de mesure. Le dispositif 4 de mesure est connecté par liaison filaire au boitier 36. Le dispositif 4 de mesure peut comprendre plusieurs supports 24. Aussi le boitier 36 peut jouer un rôle de commutateur.

Il en est de même dans la forme de réalisation dans laquelle les extrémités de piste sont nues à savoir sans boitier, l'une des extrémités étant fixée à l'intérieur de l'aéronef et l'autre extrémité à l'extérieur. Les extrémités 30, 32 sont fixées à proximité de la porte 12, 14 au niveau de laquelle le circuit flex est installé à une distance telle qu'une fois le circuit flex apposé contre la surface du plancher, de la zone de transition et du fuselage, les extrémités respectivement intérieure 30 et extérieure 32 du circuit flex se trouvent positionnées pour permettre la liaison aux zones de contact et une superposition et fixation à plat au moins au niveau de la zone de transition et dans la forme illustrée sur toute sa longueur n'induisant aucun effort sur le joint 13 et évitant de créer un espace ayant un effet sur l'étanchéité de la fermeture de porte au niveau des fuites d'air et mais également du bruit associé.

Plusieurs circuits 28 flex peuvent être prévus positionnés respectivement au niveau d'une même porte et par exemple deux circuits flex, ou au niveau d'au moins deux portes différentes, et par exemple un ou deux circuits flex par porte. Cela peut permettre de les placer au plus près des dispositifs de mesure installés sur la surface extérieure du fuselage.

## Revendications

1. Engin mobile comprenant un fuselage (8) présentant au moins une porte (12, 14), à l'intérieur duquel se trouve une unité (26) de traitement de mesures réalisées par au moins un dispositif (4) de mesure installé à l'extérieur dudit fuselage (8), le système de communication entre l'unité (26) de traitement et le dispositif (4) de mesure comprenant un circuit (28) flex, **caractérisé en ce que** le circuit (28) flex est apposé au moins partiellement à plat au niveau de l'encoignure de porte entre la porte (12, 14) et le bord (18) de l'ouverture (16) pratiquée dans le fuselage auquel la porte s'associe et dont l'une des extrémités intérieure (30) se trouve à l'intérieur du fuselage (8) et l'autre extérieure (32) à l'extérieur.

2. Engin mobile selon la revendication 1, **caractérisé en ce que** le circuit (28) flex est positionné à plat sur toute sa longueur contre la surface sur laquelle il s'applique de part et d'autre de la porte (12, 14).

3. Engin mobile selon l'une des revendications précédentes, **caractérisé en ce que** le circuit (28) flex est fixé de manière amovible sur la surface extérieure du fuselage, sur la zone de transition (31) et sur la surface d'une structure intérieure (11).

4. Engin mobile selon l'une des revendications précédentes, **caractérisé en ce que** deux boitiers (34, 36) de connexion sont prévus à l'intérieur et à l'extérieur du fuselage (8) pour la connexion directe des extrémités (30, 32) du circuit (28) flex.

5. Engin mobile selon l'une des revendications précédentes, **caractérisé en ce que** le circuit flex comprend des renforts (40) de protection au niveau d'au moins une arête (38) de l'encoignure de porte.

6. Engin mobile selon l'une des revendications précédentes, **caractérisé en ce que** le circuit flex comprend un blindage de protection contre la foudre.

7. Engin mobile selon la revendication 6, **caractérisé en ce qu'**une zone d'interruption du blindage est prévue au niveau de l'encoignure de porte.

8. Engin mobile selon l'une des revendications précédentes, **caractérisé en ce que** le circuit flex (28) comprend une extension (42) permettant d'atteindre un point de masse de l'aéronef.

9. Engin mobile selon la revendication 8, **caractérisé en ce que** l'extension (42) comprend une zone (44) dépourvue de couche d'isolant et au niveau de laquelle est prévu un pont (46) conducteur pour le passage de la foudre vers un point de masse de l'aéronef.

10. Engin mobile selon l'une des revendications précédentes, **caractérisé en ce que** le ou les dispositifs (4) de mesure sont positionnés sur la surface extérieure de l'aéronef et liés par liaison filaire à l'extrémité extérieure du circuit flex.

11. Engin mobile selon l'une des revendications précédentes, **caractérisé en ce que** plusieurs circuits (28) flex sont positionnés respectivement au niveau d'au moins deux portes différentes.

12. Engin mobile selon l'une des revendications précédentes, **caractérisé en ce qu'**il consiste en un aéronef. ]

## Patentansprüche

1. Bewegliche Maschine, die einen Rumpf (8) umfasst, der wenigstens eine Tür (12, 14) aufweist und in dessen Innerem sich eine Einheit (26) zur Verarbeitung von Messungen befindet, die von einer außerhalb des Rumpfes (8) angebrachten Messvorrichtung (4) durchgeführt werden, wobei das System zur Kommunikation zwischen der Verarbeitungseinheit (26) und der Messvorrichtung (4) eine Flex-Schaltung (28) umfasst, **dadurch gekennzeichnet, dass** die Flex-Schaltung (28) wenigstens teilweise flach an dem Türwinkel zwischen der Tür (12, 14) und dem Rand (18) der in dem Rumpf, mit dem die Tür verbunden ist, ausgebildeten Öffnung (16) angebracht ist und das eine ihrer Enden, das innere (30), sich im Inneren des Rumpfes (8) und das andere, äußere (32) an der Außenseite befindet.

2. Bewegliche Maschine nach Anspruch 1, **dadurch gekennzeichnet, dass** die Flex-Schaltung (28) auf ihrer gesamten Länge flach an der Fläche anliegend positioniert ist, auf welcher sie beiderseits der Tür (12, 14) angebracht ist.

3. Bewegliche Maschine nach einem der vorhergehenden Ansprüche, **dadurch gekennzeichnet, dass** die Flex-Schaltung (28) lösbar auf der Außenfläche des Rumpfes, auf dem Übergangsbereich (31) und auf der Oberfläche einer inneren Struktur (11) befestigt ist.

4. Bewegliche Maschine nach einem der vorhergehenden Ansprüche, **dadurch gekennzeichnet, dass** zwei Anschlusskästen (34, 36) im Inneren und an der Außenseite des Rumpfes (8) für den direkten Anschluss der Enden (30, 32) der Flex-Schaltung (28) vorgesehen sind.

5. Bewegliche Maschine nach einem der vorhergehenden Ansprüche, **dadurch gekennzeichnet, dass** die Flex-Schaltung Schutzverstärkungen (40) an wenigstens einer Kante (38) des Türwinkels umfasst.

6. Bewegliche Maschine nach einem der vorhergehenden Ansprüche, **dadurch gekennzeichnet, dass** die Flex-Schaltung eine Blitzschutzverkleidung umfasst.

7. Bewegliche Maschine nach Anspruch 6, **dadurch gekennzeichnet, dass** am Türwinkel ein Unterbrechungsbereich der Verkleidung vorgesehen ist.

8. Bewegliche Maschine nach einem der vorhergehenden Ansprüche, **dadurch gekennzeichnet, dass** die Flex-Schaltung (28) eine Erweiterung (42) umfasst, die es ermöglicht, einen Massepunkt des Luftfahrzeugs zu erreichen.

9. Bewegliche Maschine nach Anspruch 8, **dadurch gekennzeichnet, dass** die Erweiterung (42) einen Bereich (44) umfasst, der nicht mit einer Isolatorschicht versehen ist und an dem eine leitfähige Brücke (46) für den Durchgang des Blitzes zu einem Massepunkt des Luftfahrzeugs vorgesehen ist.

10. Bewegliche Maschine nach einem der vorhergehenden Ansprüche, **dadurch gekennzeichnet, dass** die Messvorrichtung oder Messvorrichtungen (4) auf der Außenfläche des Luftfahrzeugs positioniert sind und über eine Drahtverbindung mit dem äußeren Ende der Flex-Schaltung verbunden sind.

11. Bewegliche Maschine nach einem der vorhergehenden Ansprüche, **dadurch gekennzeichnet, dass** mehrere Flex-Schaltungen (28) an wenigstens zwei verschiedenen jeweiligen Türen positioniert sind.

12. Bewegliche Maschine nach einem der vorhergehenden Ansprüche, **dadurch gekennzeichnet, dass** sie aus einem Luftfahrzeug besteht.

## Claims

1. Mobile machine comprising a fuselage (8) having at least one door (12, 14), inside which is located a unit (26) for processing measurements taken by at least one measurement device (4) installed outside said fuselage (8), the system for communication between the processing unit (26) and the measurement device (4) comprising a flex circuit (28), **characterized in that** the flex circuit (28) is affixed at least partially flat in the door corner between the door (12, 14) and the rim (18) of the opening (16) formed in the fuselage with which the door is associated and one of the ends, the internal end (30), of which is located inside the fuselage (8) and the other, external, end (32) of which is located outside.

2. Mobile machine according to Claim 1, **characterized in that** the flex circuit (28) is positioned flat along its entire length against the surface to which it is applied on either side of the door (12, 14).

3. Mobile machine according to either of the preceding claims, **characterized in that** the flex circuit (28) is removably attached to the external surface of the fuselage, to the transition zone (31) and to the surface of an inside structure (11).

4. Mobile machine according to one of the preceding claims, **characterized in that** two connection housings (34, 36) are provided on the inside and on the outside of the fuselage (8) for directly connecting the ends (30, 32) of the flex circuit (28) .

5. Mobile machine according to one of the preceding claims, **characterized in that** the flex circuit comprises protective reinforcements (40) at at least one edge (38) of the door corner.

6. Mobile machine according to one of the preceding claims, **characterized in that** the flex circuit comprises shielding for protection from lightning.

7. Mobile machine according to Claim 6, **characterized in that** a zone in which the shielding is interrupted is provided in the door corner.

8. Mobile machine according to one of the preceding claims, **characterized in that** the flex circuit (28) comprises an extension (42) allowing a ground point of the aircraft to be reached.

9. Mobile machine according to Claim 8, **characterized in that** the extension (42) comprises a zone (44) that is free of insulating layer and at the site of which a conductive bridge (46) for conducting lightning to a ground point of the aircraft is provided.

10. Mobile machine according to one of the preceding claims, **characterized in that** the one or more measurement devices (4) are positioned on the external surface of the aircraft and connected by wired connection to the external end of the flex circuit.

11. Mobile machine according to one of the preceding claims, **characterized in that** a plurality of flex circuits (28) are respectively positioned at the sites of at least two different doors.

12. Mobile machine according to one of the preceding claims, **characterized in that** it is an aircraft.
